# EUROPEAN PATENT SPECIFICATION

(11) **EP 4 414 346 B1**
(45) Date of publication and mention of the grant of the patent: **03.12.2025**
(21) Application number: 24156944.1
(22) Date of filing: 09.02.2024
(51) Int. Cl.: C04B 41/00, C04B 35/80, C04B 41/52, C04B 41/89, C23C 16/458, C23C 16/04

(54) **COATINGS FOR TOOLING**
BESCHICHTUNGEN FÜR WERKZEUGE
REVÊTEMENTS POUR OUTILLAGE

(30) Priority: 10.02.2023 US 202363444654 P
(43) Date of publication of application: 14.08.2024
(73) Proprietor: RTX Corporation, Farmington, CT 06032 (US)
(72) Inventor: SHE, Ying, East Hartford, 06118 (US); LAZUR, Andrew Joseph, East Hartford, 06118 (US); COLBY, Mary, East Hartford, 06118 (US)
(74) Representative: Dehns

(56) References cited:
- EP-A1- 1 815 975
- EP-A1- 3 805 424
- FR-A1- 3 132 242
- US-A1- 2013 302 616
- US-B1- 6 413 321

## Description

### BACKGROUND

The present invention relates generally to the manufacture of ceramic matrix composite (CMC) parts and more particularly to tooling fixtures used in chemical vapor deposition/chemical vapor infiltration (CVD/CVI) processing.

CMC parts are widely fabricated by densifying preforms that are made from woven fabric tows. CVI is one of the most used densification techniques in industry. Perforated tooling is commonly used to hold the preforms during the initial densification cycle(s) to keep the preform in a rigid form and maintain proper shape and geometry (see for instance EP3805424A1 or EP1815975A1). After the initial densification cycle(s), when the preform is rigid enough to stand alone in a subsequent densification process, detooling is performed to remove the preform from the tooling.

Delamination of the preform can occur during the detooling process if the preform sticks to the tooling. Delamination can damage the preform to the extent that the preform is unusable and the process must be restarted with a new fiber preform.

### SUMMARY

In one aspect, a tooling fixture is disclosed for densification by chemical vapor infiltration of a fiber preform of a ceramic matrix composite. The tooling fixture includes a body having oppositely disposed first and second surfaces and a plurality of holes extending between the first and second surfaces, and a coating. The first surface is configured to be disposed adjacent to the fiber preform. The coating is disposed on the first surface and surfaces defining the plurality of holes. The coating comprises at least one of a ceramic material, hexagonal boron nitride, turbostratic boron nitride, and graphite.

In another aspect, a method of forming a ceramic matrix composite includes disposing a fiber preform in a tooling fixture, placing the tooling fixture with the fiber preform in a chemical vapor infiltration reactor, at least partially densifying the fiber preform with a ceramic matrix through a process of chemical vapor infiltration, and releasing the at least partially densified fiber preform from the tooling fixture. The tooling fixture includes a coating disposed on fiber preform-facing surfaces and surfaces defining holes through the tooling fixture. The coating includes at least one of a ceramic material, hexagonal boron nitride, turbostratic boron nitride, and graphite. The at last partially densified fiber preform is released without delamination of the partially densified fiber preform.

In yet another aspect, a method of forming a ceramic matrix composite includes disposing a fiber preform in a tooling fixture, placing the tooling fixture with the fiber preform in a chemical vapor infiltration reactor, at least partially densifying the fiber preform with a ceramic matrix through a process of chemical vapor infiltration, and releasing the at least partially densified fiber preform from the tooling fixture. The tooling includes a coating disposed on fiber preform-facing surfaces and surfaces defining holes through the tooling fixture. The coating comprises at least one of a ceramic material, hexagonal boron nitride, turbostratic boron nitride, and graphite. The at last partially densified fiber preform is released without delamination of the partially densified fiber preform.

Features of embodiments are set forth in the dependent claims.

The present summary is provided only by way of example, and not limitation. Other aspects of the present disclosure will be appreciated in view of the entirety of the present disclosure, including the entire text, claims and accompanying figures.

### BRIEF DESCRIPTION OF THE DRAWINGS

FIG. 1 is a simplified perspective view of a tooling fixture for CMC manufacture via chemical vapor deposition/chemical vapor infiltration.
FIG. 2 is a simplified enlarged cross-sectional view of the tooling fixture of FIG. 1 having a coating.
FIG. 3 is a flow chart of a method for forming one embodiment of the coating of FIG. 2.
FIG. 4 is a flow chart of a method for forming another embodiment of the coating of FIG. 2.
FIG. 5 is a flow chart of a method for forming yet another embodiment of the coating of FIG. 2.
FIG. 6 is a simplified enlarged cross-sectional view of the tooling fixture of FIG. 1 having a multi-layer coating.
FIG. 7 is a flow chart of a method for forming one embodiment of the multi-layer coating of FIG. 6
FIG. 8 is a flow chart of a method for forming another embodiment of the multi-layer coating of FIG. 6.

While the above-identified figures set forth one or more embodiments of the present disclosure, other embodiments are also contemplated, as noted in the discussion. In all cases, this disclosure presents the invention by way of representation and not limitation. It should be understood that numerous other modifications and embodiments can be devised by those skilled in the art, which fall within the scope of the invention. The figures may not be drawn to scale, and applications and embodiments of the present invention may include features and components not specifically shown in the drawings.

### DETAILED DESCRIPTION

The present disclosure is directed to various coatings that can be applied to a tooling fixture used in CVI processes for initial densification of preforms in the manufacture of CMC components. The disclosed coatings can be applied to surfaces of the tooling fixture to aid in release of the preform following an initial densification process and to prevent delamination of the preform. The disclosed coatings can additionally seal the tooling fixture to prevent residue from the tooling fixture from contaminating the preform during the CVI process.

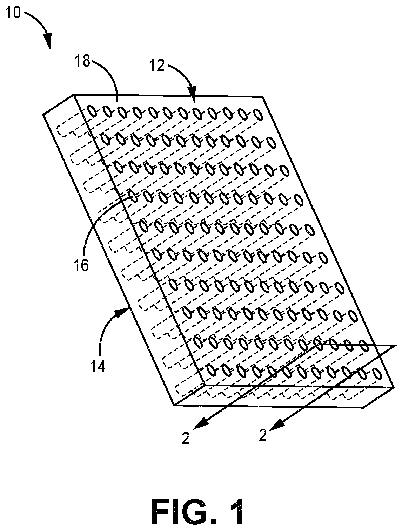

FIG. 1 is a simplified perspective view of a perforated tooling fixture that can be used in a CVI densification process. Tooling fixture 10 includes inner surface 12, oppositely disposed outer surface 14, holes 16, and coating 18. Holes 16 extend through a thickness of tooling fixture 10 between inner surface 12 and outer surface 14. Holes 16 open to inner surface 12 and outer surface 14. Coating 18 can be disposed on inner surface 12, outer surface 14, and surfaces defining holes 16.

Tooling fixture 10 can be used in combination with one or more tooling fixtures as known in the art to at least partially enclose a preform to help maintain a shape of the preform during CVI processing. Tooling fixture 10 can have any shape or configuration depending on the geometry of the final CMC component. Inner surface 12 is a preform-facing surface. Holes 16 are configured to deliver a reactant gas to the preform during CVI. Tooling fixture 10 can be formed from graphite. The preform (not shown) can be formed from tows of fibers arranged in a three-dimensional (3D) weave or a single or plurality of stacked two-dimensional (2D) woven fiber plies as known in the art. The preform can be formed from non-woven (e.g., chopped, felted, etc.) fibers. Suitable fiber materials include, but are not limited to carbon, silicon carbide (SiC), alloyed and/or zirconium carbide, hafnium carbide, aluminum silicate, alumina, glass ceramic, and other materials suitable for high temperature operation.

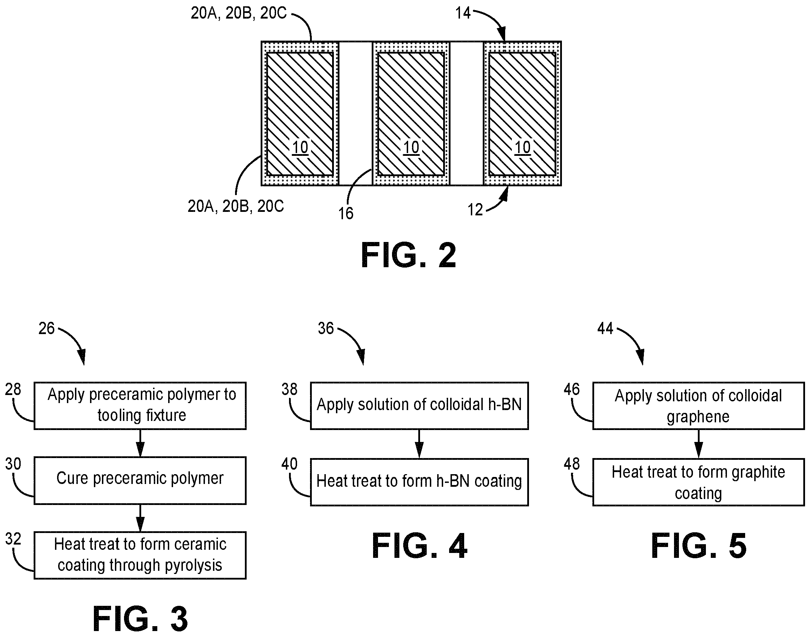

Tooling fixture 10 includes coating 18 on inner surface 12 and surfaces defining holes 16. In some embodiments, coating 18 can be applied to all surfaces of tooling fixture 10 such that coating 18 fully encases tooling fixture 10. Coating 18 can function to aid in the release of the preform during a process of detooling or removing the preform from tooling fixture 10 once the preform has a rigidity sufficient to maintain a shape outside of tooling fixture 10 in subsequent CVI processing. Coating 18 can additionally function to seal tooling fixture 10 to prevent residue from tooling fixture 10 from contaminating the preform during the CVI process. Coating 18 can be any of a variety of coatings disclosed herein and discussed with respect to FIGS. 2-8.

FIG. 2 is a simplified enlarged cross-sectional view of tooling fixture 10 taken along the 2-2 line of FIG. 1 and having a coating according to one set of embodiments of the present disclosure. Tooling fixture 10, inner surface 12, outer surface 14, holes 16, and coating 20A, 20B, 20C are shown. Any one of coatings 20A, 20B, and 20C can be applied to tooling fixture 10. FIG. 3 is a flow chart of method 26 for forming coating 20A. FIG. 4 is a flow chart of method 36 for forming coating 20B. FIG. 5 is a flow chart of method 44 for forming coating 20C. FIGS. 2-5 are discussed together herein.

In one embodiment, tooling fixture 10 can be coated with coating 20A. Coating 20A is a ceramic material. Coating 20A can be, for example, SiC or silicon nitride (Si₃N₄). Coating 20A can be a polymer derived ceramic formed according to method 26. Coating 20A, can be formed, for example, from polymeric materials, and specifically, a preceramic polymer. The preceramic polymer can be, for example, a polycarbosilane such as polydimethylsilane. The preceramic polymer can be provided in a liquid phase, which can be applied to tooling fixture 10 in step 28 by one of a variety of methods, including but not limited to brushing/painting, or spraying to provide tooling fixture 10 with a preceramic polymer intermediate coating layer. Ceramic coatings formed of preceramic polymers according to method 26 can have a porous microstructure as compared to dense ceramic coatings formed via CVI.

The preceramic polymer intermediate coating layer can be cured on tooling fixture 10 in step 30 to produce a cured coating layer. Curing can include heat treatment in air or in an inert atmosphere. Curing can be conducted, for example, at a temperature of approximately 190 °C for less than approximately 30 minutes. Curing time can vary depending on a thickness of the intermediate preceramic polymer coating layer applied to tooling fixture 10 in step 28.

The cured coating layer can undergo a second heat treatment and pyrolysis in step 32 to form ceramic coating 20A. Pyrolysis can be conducted, for example, in a CVI reactor at a temperature ranging from about 1100 °C to 1300 °C. Step 32 can be performed under vacuum or in a desired atmosphere (i.e., inert or reactive atmosphere). Step 32 can generally be conducted in less than 30 minutes.

In one embodiment, coating 20A can be SiC. SiC can be formed using method 26 starting with the preceramic polymer polydimethylsilane and pyrolysis in an inert (nitrogen) atmosphere. In another embodiment, coating 20A can be Si₃N₄. Si₃N₄ can be formed using method 26 starting with the preceramic polymer polydimethylsilane and with the addition of ammonia gas during pyrolysis (step 32). Coating 20A can be other ceramic materials formed using method 26 and is not limited to SiC and Si₃N₄.

In another embodiment, tooling fixture 10 can be coated with coating 20B. Coating 20B can be hexagonal boron nitride (h-BN) formed according to method 36 shown in FIG. 4. Hexagonal boron nitride has a layered structure with layers held together by weak van der Waals forces, which can aid in the release of the preform from tooling fixture 10. Additionally, hexagonal boron nitride is chemically inert under CVI process conditions. In other embodiments, tooling fixture 10 can be coated with turbostratic boron nitride.

A colloidal solution of h-BN can be applied in step 38 to form an intermediate colloidal solution coating layer on tooling fixture 10. The intermediate colloidal solution of h-BN can be applied using any of a variety of methods including, but not limited to, brushing/painting or spraying. The colloidal solution of h-BN can be prepared using a known exfoliation and dispersion process, forming an h-BN flake colloidal solution comprising h-BN flakes of approximately 2.5 nm thick and 100-200 nm in lateral size. Concentrations of h-BN can range from, for example, 0.3 to 30 mg/ml (30 mg/cm³).

The colloidal h-BN solution coating layer can be dried on tooling fixture 10 and can be heat treated in step 40. Heat treating removes volatile organic compounds from the colloidal h-BN solution coating layer, providing an h-BN coating on tooling fixture 10.

In alternative embodiments, coating 20B can be h-BN or turbostratic BN formed on tooling fixture 10 via a CVD process.

In yet another embodiment, tooling fixture 10 can be coated with coating 20C. Coating 20C can be graphite formed according to method 44 shown in FIG. 5. Like hexagonal boron nitride, graphite has a layered structure with weak strength between layers and is chemically inert under CVI process conditions.

A colloidal solution of graphene can be applied in step 46 to form an intermediate colloidal solution coating layer on tooling fixture 10. The intermediate colloidal solution of graphene can be applied using any of a variety of methods including, but not limited to, brushing/painting or spraying. Colloidal dispersions of graphene can be prepared using known methods of ball milling multi-layered graphene sheets in organic solvent. For example, graphite (multi-layered graphene sheets) having a starting thickness of 30 to 80 nm and lateral size of around 5 to 20 µm can be ball milled in an organic solvent such as dimethylformamide (MMF) to form graphite flakes having a thickness of around 0.5 nm and lateral size of around 100 to 200 nm.

The colloidal solution coating layer can be dried on tooling fixture 10 and can be heat treated in step 48. Heat treating removes volatile organic compounds from the colloidal graphene solution coating layer, providing a graphite coating on tooling fixture 10.

A thickness of coating 20A, 20B, 20C can range from approximately 20 nm to 2000 nm. A coating thickness of 2000 nm does not effectively change the hole size in tooling fixture 10 (e.g., much less than 1% reduction of hole size).

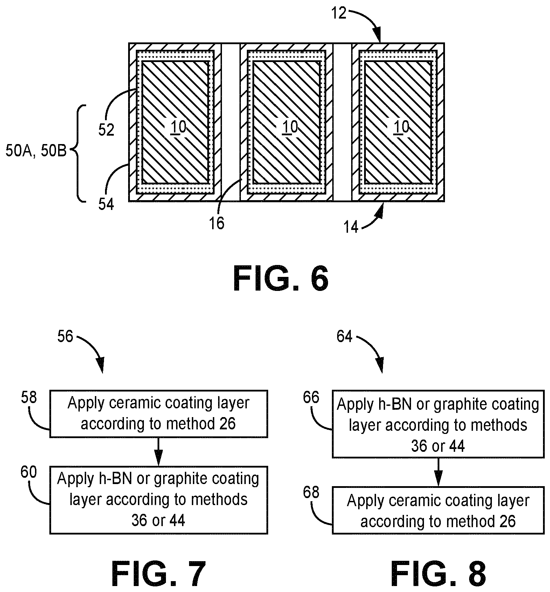

FIG. 6 is a simplified enlarged cross-sectional view of tooling fixture 10 of FIG. 1 having a multi-layer coating according to another set of embodiments of the present disclosure. Tooling fixture 10, inner surface 12, outer surface 14, holes 16, and coating 50A, 50B including inner coating layer 52 and outer coating layer 54 are shown. FIG. 7 is a flow chart of method 56 for forming coating 50A, 50B of FIG. 6. FIG. 8 is a flow chart of method 64 for forming coating 50A, 50B of FIG. 6. FIGS. 6-8 are discussed together herein.

Coating 50A, 50B includes inner coating layer 52 disposed on tooling fixture 10 and outer coating layer 54 disposed on inner coating layer 52. Outer coating layer 54 interfaces with the preform during CVI processing.

In one embodiment, tooling fixture 10 can be coated with coating 50A. Coating 50A includes inner coating layer 52 formed of a ceramic coating and outer coating layer 54 formed of h-BN or graphite. Inner coating layer 52 can be, for example, SiC, Si₃N₄, or other polymer-derived ceramic material as previously discussed.

Coating 50A can be formed according to method 56 shown in FIG. 7. In step 58, a ceramic coating can be formed on surfaces of tooling fixture 10 according to method 26 of FIG. 3, providing inner coating layer 52. Outer coating layer 54 can be provided, in step 60, following formation of the ceramic coating (inner coating layer 52). In step 60, a h-BN coating or a graphene coating can be applied to inner coating according to methods 36 and 44 of FIGS. 4 and 5, respectively.

A thickness of coating 50A can range from approximately 40 nm to 2000 nm. A thickness of inner coating layer 52 can range from approximately 20 nm to 1000 nm. A thickness of outer coating layer 54 can range from approximately 20 nm to 1000 nm.

In another embodiment, tooling fixture 10 can be coated with coating 50B. Coating 50B includes inner coating layer 52 formed of a h-BN coating or graphite coating and outer coating layer 54 formed of a ceramic material. Outer coating layer 54 can be, for example, SiC, Si₃N₄, or other polymer-derived ceramic material as previously discussed.

Coating 50B can be formed according to method 64 shown in FIG. 8. In step 66, a h-BN coating or a graphene coating can be applied to surfaces of tooling fixture 10 according to methods 36 and 44 of FIGS. 4 and 5, respectively. Outer coating layer 54 can be provided, in step 68, following formation of the h-BN or graphite coating (inner coating layer 52). In step 68, a ceramic coating can be applied to according to method 26 of FIG. 3 to form outer coating layer 54.

A thickness of coating 50B can range from approximately 40 nm to 2000 nm. A thickness of inner coating layer 52 can range from approximately 20 nm to 1000 nm. A thickness of outer coating layer 54 can range from approximately 20 nm to 1000 nm.

The disclosed coatings can be provided to a perforated tooling fixture used for CVD/CVI processes to aid in the release of a partially densified CMC preform and prevent delamination of the CMC preform during detooling. The disclosed coatings can also effectively seal the perforated tooling fixture and prevent residue from being released from the tooling fixture during CVD/CVI processing.

### Discussion of Possible Embodiments

The following are non-exclusive descriptions of possible embodiments of the present invention.

A tooling fixture is disclosed for densification by chemical vapor infiltration of a fiber preform of a ceramic matrix composite. The tooling fixture includes a body having oppositely disposed first and second surfaces and a plurality of holes extending between the first and second surfaces and a coating disposed on the first surface and surfaces defining the plurality of holes. The first surface is configured to be disposed adjacent to the fiber preform. The coating includes at least one of a ceramic material, hexagonal boron nitride, turbostratic boron nitride, and graphite.

The tooling fixture of the preceding paragraph can optionally include, additionally and/or alternatively, any one or more of the following features, configurations and/or additional components:
In an embodiment of the tooling fixture of foregoing paragraph, the coating comprises silicon carbide or silicon nitride.

In a further embodiment of the tooling fixture of any of the foregoing paragraphs, the coating can comprise an inner layer formed of the ceramic material and an outer layer disposed on the inner layer, the outer layer formed of hexagonal boron nitride, turbostratic boron nitride, or graphite.

In a further embodiment of the tooling fixture of any of the foregoing paragraphs, the coating can comprise an inner layer formed of the hexagonal boron nitride, turbostratic boron nitride, or graphite and an outer layer disposed on the inner layer, the outer layer formed of the ceramic material.

In a further embodiment of the tooling fixture of any of the foregoing paragraphs, the coating can comprise a polymer derived ceramic.

In a further embodiment of the tooling fixture of any of the foregoing paragraphs, the coating can comprise hexagonal boron nitride

In a further embodiment of the tooling fixture of any of the foregoing paragraphs, the coating can be disposed on the second surface

A method of forming a ceramic matrix composite includes disposing a fiber preform in a tooling fixture, placing the tooling fixture with the fiber preform in a chemical vapor infiltration reactor, at least partially densifying the fiber preform with a ceramic matrix through a process of chemical vapor infiltration, and releasing the at least partially densified fiber preform from the tooling fixture. The tooling fixture includes a coating disposed on fiber preform-facing surfaces and surfaces defining holes through the tooling fixture. The coating includes at least one of a ceramic material, hexagonal boron nitride, turbostratic boron nitride, and graphite. The at last partially densified fiber preform is released without delamination of the partially densified fiber preform.

The method of the preceding paragraph can optionally include, additionally and/or alternatively, any one or more of the following features, configurations, additional components, and/or steps:
In a further embodiment of the foregoing method, heat-treating can include curing the first intermediate coating, the intermediate coating comprising a preceramic polymer, and converting the preceramic polymer to a ceramic material through pyrolysis.

In a further embodiment of the method of any of the foregoing paragraphs, the first intermediate coating can comprise a polycarbosilane.

In a further embodiment of the method of any of the foregoing paragraphs, pyrolysis can be conducted in the presence of ammonia.

An embodiment of the method of any of the foregoing methods can further include applying a second intermediate coating to a preform-facing surface of the tooling fixture, applying the second intermediate coating to surfaces defining holes of the tooling fixture, and heat-treating the second intermediate coating on the tooling fixture to form a second final coating. The second intermediate coating can include at least one of colloidal hexagonal boron nitride and colloidal graphene.

In a further embodiment of the method of any of the foregoing paragraphs, the first final coating can be formed on the second final coating.

In a further embodiment of the method of any of the foregoing paragraphs, the intermediate coating can be applied by brushing or spraying.

A method of forming a ceramic matrix composite includes disposing a fiber preform in a tooling fixture, placing the tooling fixture with the fiber preform in a chemical vapor infiltration reactor, at least partially densifying the fiber preform with a ceramic matrix through a process of chemical vapor infiltration, and releasing the at least partially densified fiber preform from the tooling fixture. The tooling includes a coating disposed on fiber preform-facing surfaces and surfaces defining holes through the tooling fixture. The coating comprises at least one of a ceramic material, hexagonal boron nitride, and graphite. The at last partially densified fiber preform is released without delamination of the partially densified fiber preform.

The method of the preceding paragraph can optionally include, additionally and/or alternatively, any one or more of the following features, configurations, additional components, and/or steps:
In a further embodiment of the foregoing method, the coating can comprise a first layer formed of the ceramic material and a second layer formed of the hexagon-boron nitride or graphite.

In a further embodiment of the method of any of the foregoing paragraphs, the first layer can be disposed on the second layer, the first layer disposed adjacent to the fiber preform.

In a further embodiment of the method of any of the foregoing paragraphs, the second layer can be disposed on the first layer, the second layer disposed adjacent to the fiber preform.

In a further embodiment of the method of any of the foregoing paragraphs, the coating can comprise silicon carbide.

In a further embodiment of the method of any of the foregoing paragraphs, the coating can comprise silicon nitride.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A tooling fixture (10) for densification by chemical vapor infiltration of a fiber preform of a ceramic matrix composite, the tooling fixture (10) comprising:
a body having oppositely disposed first and second surfaces (12, 14) and a plurality of holes (16) extending between the first and second surfaces (12, 14), the first surface (12) configured to be disposed adjacent to the fiber preform;
a coating (18; 20A, 20B, 20C; 50A, 50B) disposed on the first surface (12) and surfaces defining the plurality of holes (16), the coating (18; 20A, 20B, 20C; 50A, 50B) comprising at least one of a ceramic material, hexagonal boron nitride, turbostratic boron nitride, and graphite.

2. The tooling fixture of claim 1, wherein the coating (18; 20A, 20B, 20C; 50A, 50B) comprises silicon carbide or silicon nitride.

3. The tooling fixture of claim 1 or 2, wherein the coating (50A, 50B) comprises an inner layer (52) formed of the ceramic material and an outer layer (54) disposed on the inner layer (52), the outer layer (54) formed of hexagonal boron nitride, turbostratic boron nitride, or graphite.

4. The tooling fixture of claim 1 or 2, wherein the coating (50A, 50B) comprises an inner layer (52) formed of the hexagonal boron nitride or graphite and an outer layer (54) disposed on the inner layer (52), the outer layer (54) formed of the ceramic material.

5. The tooling fixture of any preceding claim, wherein the coating (18; 20A, 20B, 20C; 50A, 50B) comprises a polymer derived ceramic; and/or hexagonal boron nitride.

6. The tooling fixture of any preceding claim, wherein the coating (18; 20A, 20B, 20C; 50A, 50B) is disposed on the second surface (14).

7. A method of coating a tooling fixture (10) configured to contact a fiber preform in a process of densification of the fiber preform by chemical vapor infiltration to form a ceramic matrix, the method comprising:
applying a first intermediate coating to a preform-facing surface (12) of the tooling fixture (10);
applying the first intermediate coating to surfaces defining holes (16) of the tooling fixture (10); and
heat-treating the first intermediate coating on the tooling fixture (10) to form a first final coating (18; 20A, 20B, 20C; 50A);
wherein the first intermediate coating comprises at least one of a preceramic polymer, colloidal hexagonal boron nitride, and colloidal graphene.

8. The method of claim 7, wherein heat-treating comprises:
curing the first intermediate coating, the intermediate coating comprising a preceramic polymer, optionally comprising polycarbosilane; and
converting the preceramic polymer to a ceramic material through pyrolysis.

9. The method of claim 8, wherein pyrolysis is conducted in the presence of ammonia.

10. The method of claim 8 or 9, further comprising
applying a second intermediate coating to the preform-facing surface (12) of the tooling fixture (10);
applying the second intermediate coating to surfaces defining holes (16) of the tooling fixture (10); and
heat-treating the second intermediate coating on the tooling fixture (10) to form a second final coating (50B);
wherein the second intermediate coating comprises at least one of colloidal hexagonal boron nitride and colloidal graphene;
optionally, wherein the first final coating (50A) is formed on the second final coating (50B).

11. The method of any of claims 7 to 10, wherein the intermediate coating is applied by brushing or spraying.

12. A method of forming a ceramic matrix composite, the method comprising:
disposing a fiber preform in a tooling fixture (10), the tooling fixture (10) comprising a coating (18; 20A, 20B, 20C; 50A, 50B) disposed on fiber preform-facing surfaces (12) and surfaces defining holes (16) through the tooling fixture (10), wherein the coating (18; 20A, 20B, 20C; 50A, 50B) comprises at least one of a ceramic material, hexagonal boron nitride, and graphite;
placing the tooling fixture (10) with the fiber preform in a chemical vapor infiltration reactor;
at least partially densifying the fiber preform with a ceramic matrix through a process of chemical vapor infiltration;
releasing the at least partially densified fiber preform from the tooling fixture (10), wherein the at last partially densified fiber preform is released without delamination of the partially densified fiber preform.

13. The method of claim 12, wherein the coating (50A, 50B) comprises a first layer (52; 54) formed of the ceramic material and a second layer (54; 52) formed of the hexagon-boron nitride or graphite.

14. The method of claim 13, wherein:
the first layer (54) is disposed on the second layer (52), the first layer (54) disposed adjacent to the fiber preform; or
the second layer (54) is disposed on the first layer (52), the second layer (54) disposed adjacent to the fiber preform.

15. The method of any of claims 12 to 14, wherein: the coating (18; 20A, 20B, 20C; 50A, 50B) comprises silicon carbide or silicon nitride.

## Patentansprüche

1. Werkzeugeinrichtung (10) zur Verdichtung einer Faservorform eines Keramikmatrix-Verbundwerkstoffs durch chemische Gasphaseninfiltration, wobei die Werkzeugvorrichtung (10) Folgendes umfasst:
einen Körper, der eine erste und zweite Fläche (12, 14), die einander gegenüberliegend angeordnet sind, und eine Vielzahl von Löchern (16) aufweist, die sich zwischen der ersten und zweiten Fläche (12, 14) erstreckt, wobei die erste Fläche (12) derart konfiguriert ist, dass sie benachbart zu der Faservorform angeordnet ist;
eine Beschichtung (18; 20A, 20B, 20C; 50A, 50B), die auf der ersten Fläche (12) und die Vielzahl von Löchern (16) definierenden Flächen angeordnet ist, wobei die Beschichtung (18; 20A, 20B, 20C; 50A, 50B) mindestens eines von einem Keramikmaterial, hexagonalem Bornitrid, turbostratischem Bornitrid und Graphit umfasst.

2. Werkzeugeinrichtung nach Anspruch 1, wobei die Beschichtung (18; 20A, 20B, 20C; 50A, 50B) Siliciumcarbid oder Siliciumnitrid umfasst.

3. Werkzeugeinrichtung nach Anspruch 1 oder 2, wobei die Beschichtung (50A, 50B) eine aus dem Keramikmaterial ausgebildete innere Schicht (52) und eine auf der inneren Schicht (52) angeordnete äußere Schicht (54) umfasst, wobei die äußere Schicht (54) aus hexagonalem Bornitrid, turbostratischem Bornitrid oder Graphit ausgebildet ist.

4. Werkzeugeinrichtung nach Anspruch 1 oder 2, wobei die Beschichtung (50A, 50B) eine aus dem hexagonalen Bornitrid oder Graphit ausgebildete innere Schicht (52) und eine auf der inneren Schicht (52) angeordnete äußere Schicht (54) umfasst, wobei die äußere Schicht (54) aus dem Keramikmaterial ausgebildet ist.

5. Werkzeugeinrichtung nach einem der vorhergehenden Ansprüche, wobei die Beschichtung (18; 20A, 20B, 20C; 50A, 50B) eine von einem Polymer abgeleitete Keramik; und/oder hexagonales Bornitrid umfasst.

6. Werkzeugeinrichtung nach einem der vorhergehenden Ansprüche, wobei die Beschichtung (18; 20A, 20B, 20C; 50A, 50B) auf der zweiten Fläche (14) angeordnet ist.

7. Verfahren zum Beschichten einer Werkzeugeinrichtung (10), die derart konfiguriert ist, dass sie in einem Prozess der Verdichtung einer Faservorform durch chemische Gasphaseninfiltration unter Ausbilden einer Keramikmatrix mit der Faservorform in Kontakt kommt, wobei das Verfahren Folgendes umfasst:
Aufbringen einer ersten Zwischenbeschichtung auf eine der Vorform zugewandte Fläche (12) der Werkzeugeinrichtung (10);
Aufbringen der ersten Zwischenbeschichtung auf Löcher (16) der Werkzeugeinrichtung (10) definierende Flächen; und
Wärmebehandeln der ersten Zwischenbeschichtung auf der Werkzeugeinrichtung (10) unter Ausbilden einer ersten Endbeschichtung (18; 20A, 20B, 20C; 50A);
wobei die erste Zwischenbeschichtung mindestens eines von einem präkeramischen Polymer, kolloidalem hexagonalem Bornitrid und kolloidalem Graphen umfasst.

8. Verfahren nach Anspruch 7, wobei das Wärmebehandeln Folgendes umfasst:
Aushärten der ersten Zwischenbeschichtung, wobei die Zwischenbeschichtung ein präkeramisches Polymer umfasst, das optional Polycarbosilan umfasst; und
Umwandeln des präkeramischen Polymers in ein keramisches Material durch Pyrolyse.

9. Verfahren nach Anspruch 8, wobei die Pyrolyse in Gegenwart von Ammoniak durchgeführt wird.

10. Verfahren nach Anspruch 8 oder 9, ferner umfassend Aufbringen einer zweiten Zwischenbeschichtung auf die der Vorform zugewandte Fläche (12) der Werkzeugeinrichtung (10);
Aufbringen der zweiten Zwischenbeschichtung auf Löcher (16) der Werkzeugeinrichtung (10) definierende Flächen; und
Wärmebehandeln der zweiten Zwischenbeschichtung auf der Werkzeugeinrichtung (10) unter Ausbilden einer zweiten Endbeschichtung (50B);
wobei die zweite Zwischenbeschichtung mindestens eines von kolloidalem hexagonalem Bornitrid und kolloidalem Graphen umfasst;
wobei optional die erste Endbeschichtung (50A) auf der zweiten Endbeschichtung (50B) ausgebildet wird.

11. Verfahren nach einem der Ansprüche 7 bis 10, wobei die Zwischenbeschichtung durch Streichen oder Sprühen aufgebracht wird.

12. Verfahren zum Ausbilden eines Keramikmatrix-Verbundwerkstoffs, wobei das Verfahren Folgendes umfasst:
Anordnen einer Faservorform in einer Werkzeugeinrichtung (10), wobei die Werkzeugeinrichtung (10) eine Beschichtung (18; 20A, 20B, 20C; 50A, 50B) umfasst, die auf der Faservorform zugewandten Flächen (12) und Löcher (16) durch die Werkzeugvorrichtung (10) definierenden Flächen angeordnet ist, wobei die Beschichtung (18; 20A, 20B, 20C; 50A, 50B) mindestens eines von einem Keramikmaterial, hexagonalem Bornitrid und Graphit umfasst;
Platzieren der Werkzeugeinrichtung (10) mit der Faservorform in einem Reaktor für chemische Gasphaseninfiltration;
Verdichten der Faservorform mit einer Keramikmatrix mindestens teilweise durch einen Prozess der chemischen Gasphaseninfiltration;
Lösen der mindestens teilweise verdichteten Faservorform von der Werkzeugeinrichtung (10), wobei die mindestens teilweise verdichtete Faservorform ohne Delaminierung der teilweise verdichteten Faservorform gelöst wird.

13. Verfahren nach Anspruch 12, wobei die Beschichtung (50A, 50B) eine aus dem Keramikmaterial ausgebildete erste Schicht (52; 54) und eine aus dem Hexagon-Bornitrid oder Graphit ausgebildete zweite Schicht (54; 52) umfasst.

14. Verfahren nach Anspruch 13, wobei:
die erste Schicht (54) auf der zweiten Schicht (52) angeordnet ist, wobei die erste Schicht (54) benachbart zu der Faservorform angeordnet ist; oder
die zweite Schicht (54) auf der ersten Schicht (52) angeordnet ist, wobei die zweite Schicht (54) benachbart zu der Faservorform angeordnet ist.

15. Verfahren nach einem der Ansprüche 12 bis 14, wobei: die Beschichtung (18; 20A, 20B, 20C; 50A, 50B) Siliciumcarbid oder Siliciumnitrid umfasst.

## Revendications

1. Dispositif de fixation d'outillage (10) pour la densification par infiltration chimique en phase vapeur d'une préforme fibreuse d'un composite à matrice céramique, le dispositif de fixation d'outillage (10) comprenant :
un corps ayant des première et seconde surfaces disposées de manière opposée (12, 14) et une pluralité de trous (16) se prolongeant entre les première et seconde surfaces (12, 14), la première surface (12) étant configurée pour être disposée adjacente à la préforme fibreuse ;
un revêtement (18 ; 20A, 20B, 20C ; 50A, 50B) disposé sur la première surface (12) et des surfaces définissant la pluralité de trous (16), le revêtement (18 ; 20A, 20B, 20C ; 50A, 50B) comprenant au moins l'un d'un matériau céramique, du nitrure de bore hexagonal, du nitrure de bore turbostratique, et du graphite.

2. Dispositif de fixation d'outillage selon la revendication 1, dans lequel le revêtement (18 ; 20A, 20B, 20C ; 50A, 50B) comprend du carbure de silicium ou du nitrure de silicium.

3. Dispositif de fixation d'outillage selon la revendication 1 ou 2, dans lequel le revêtement (50A, 50B) comprend une couche interne (52) formée du matériau céramique et une couche externe (54) disposée sur la couche interne (52), la couche externe (54) étant formée de nitrure de bore hexagonal, de nitrure de bore turbostratique, ou de graphite.

4. Dispositif de fixation d'outillage selon la revendication 1 ou 2, dans lequel le revêtement (50A, 50B) comprend une couche interne (52) formée de nitrure de bore hexagonal ou de graphite et une couche externe (54) disposée sur la couche interne (52), la couche externe (54) étant formée de matériau céramique.

5. Dispositif de fixation d'outillage selon une quelconque revendication précédente, dans lequel le revêtement (18 ; 20A, 20B, 20C ; 50A, 50B) comprend une céramique dérivée d'un polymère ; et/ou du nitrure de bore hexagonal.

6. Dispositif de fixation d'outillage selon une quelconque revendication précédente, dans lequel le revêtement (18 ; 20A, 20B, 20C ; 50A, 50B) est disposé sur la seconde surface (14).

7. Procédé de revêtement d'un dispositif de fixation d'outillage (10) configuré pour entrer en contact avec une préforme fibreuse lors d'un processus de densification de la préforme fibreuse par infiltration chimique en phase vapeur pour former une matrice céramique, le procédé comprenant :
l'application d'un premier revêtement intermédiaire sur une surface faisant face à la préforme (12) du dispositif de fixation d'outillage (10) ;
l'application du premier revêtement intermédiaire sur des surfaces définissant des trous (16) du dispositif de fixation d'outillage (10) ; et
le traitement thermique du premier revêtement intermédiaire sur le dispositif de fixation d'outillage (10) pour former un premier revêtement final (18 ; 20A, 20B, 20C ; 50A) ;
dans lequel le premier revêtement intermédiaire comprend au moins l'un d'un polymère précéramique, du nitrure de bore hexagonal colloïdal, et du graphène colloïdal.

8. Procédé selon la revendication 7, dans lequel le traitement thermique comprend :
le durcissement du premier revêtement intermédiaire, le revêtement intermédiaire comprenant un polymère précéramique, comprenant éventuellement du polycarbosilane ; et
la conversion du polymère précéramique en un matériau céramique par pyrolyse.

9. Procédé selon la revendication 8, dans lequel la pyrolyse est réalisée en présence d'ammoniac.

10. Procédé selon la revendication 8 ou 9, comprenant également l'application d'un second revêtement intermédiaire sur la surface faisant face à la préforme (12) du dispositif de fixation d'outillage (10) ;
l'application du second revêtement intermédiaire sur des surfaces définissant des trous (16) du dispositif de fixation d'outillage (10) ; et
le traitement thermique du second revêtement intermédiaire sur le dispositif de fixation d'outillage (10) pour former un second revêtement final (50B) ;
dans lequel le second revêtement intermédiaire comprend au moins l'un du nitrure de bore hexagonal colloïdal et du graphène colloïdal ;
éventuellement, dans lequel le premier revêtement final (50A) est formé sur le second revêtement final (50B).

11. Procédé selon l'une quelconque des revendications 7 à 10, dans lequel le revêtement intermédiaire est appliqué par brossage ou par pulvérisation.

12. Procédé de formation d'un composite à matrice céramique, le procédé comprenant :
la disposition d'une préforme fibreuse dans un dispositif de fixation d'outillage (10), le dispositif de fixation d'outillage (10) comprenant un revêtement (18 ; 20A, 20B, 20C ; 50A, 50B) disposé sur des surfaces faisant face à la préforme fibreuse (12) et des surfaces définissant des trous (16) à travers le dispositif de fixation d'outillage (10), dans lequel le revêtement (18 ; 20A, 20B, 20C ; 50A, 50B) comprend au moins l'un d'un matériau céramique, du nitrure de bore hexagonal, et du graphite ;
le placement du dispositif de fixation d'outillage (10) avec la préforme fibreuse dans un réacteur d'infiltration chimique en phase vapeur ;
la densification au moins partielle de la préforme fibreuse avec une matrice céramique par un procédé d'infiltration chimique en phase vapeur ;
la libération de la préforme fibreuse au moins partiellement densifiée du dispositif de fixation d'outillage (10), dans lequel la préforme fibreuse au moins partiellement densifiée est libérée sans délaminage de la préforme fibreuse partiellement densifiée.

13. Procédé selon la revendication 12, dans lequel le revêtement (50A, 50B) comprend une première couche (52 ; 54) formée du matériau céramique et une seconde couche (54 ; 52) formée du nitrure de bore hexagonal ou du graphite.

14. Procédé selon la revendication 13, dans lequel :
la première couche (54) est disposée sur la seconde couche (52), la première couche (54) étant disposée adjacente à la préforme fibreuse ; ou
la seconde couche (54) est disposée sur la première couche (52), la seconde couche (54) étant disposée adjacente à la préforme fibreuse.

15. Procédé selon l'une quelconque des revendications 12 à 14, dans lequel : le revêtement (18 ; 20A, 20B, 20C ; 50A, 50B) comprend du carbure de silicium ou du nitrure de silicium.
